(19) Europäisches Patentamt
European Patent Office
Office européen des brevets

(11) **EP 4 406 914 A1**

(12) **EUROPEAN PATENT APPLICATION**

(43) Date of publication:
**31.07.2024 Bulletin 2024/31**

(21) Application number: **24153916.2**

(22) Date of filing: **25.01.2024**

(51) International Patent Classification (IPC):
**B81C 3/00** (2006.01)    **G01L 9/00** (2006.01)

(52) Cooperative Patent Classification (CPC):
**B81C 3/001; G01L 9/0047; G01L 19/0654;**
B81B 2201/0264; B81B 2203/0315; B81C 2201/019

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.01.2023 US 202318102070**

(71) Applicant: **ROSEMOUNT AEROSPACE INC.
Burnsville, MN 55306-4898 (US)**

(72) Inventors:
• **BACKMAN, Roger Alan
Eagan, MN, 55122 (US)**
• **FRINK, Sarah
Inver Grove Heights, MN, 55076 (US)**
• **POTASEK, David
Lakeville, MN, 55044 (US)**

(74) Representative: **Dehns
St. Bride's House
10 Salisbury Square
London EC4Y 8JD (GB)**

(54) **SYSTEMS AND METHODS FOR WAFER DIE ASSEMBLY BONDING**

(57)    A wafer die assembly includes a first wafer (102) having at least a central cavity (106) defined therein. The wafer die assembly includes a second wafer (112) mounted to the first wafer. At least one of the first or second wafers includes an etched pattern (104). The etched pattern including at least one peripheral cavity (108), and a raised area (110) raised relative to the peripheral cavity. A method of assembling a wafer die assembly includes etching a central cavity into a first wafer and etching a pattern into at least one of the first wafer or a second wafer. The first wafer and/or the second wafer includes a raised area raised relative to the peripheral cavity or the central cavity. The method includes bonding the second wafer to the first wafer.

FIG. 1

**Description**

BACKGROUND OF THE INVENTION

1. Field of the Invention

The present disclosure relates to wafer die assemblies and more particularly to wafer die assemblies used in high pressure sensors.

2. Description of Related Art

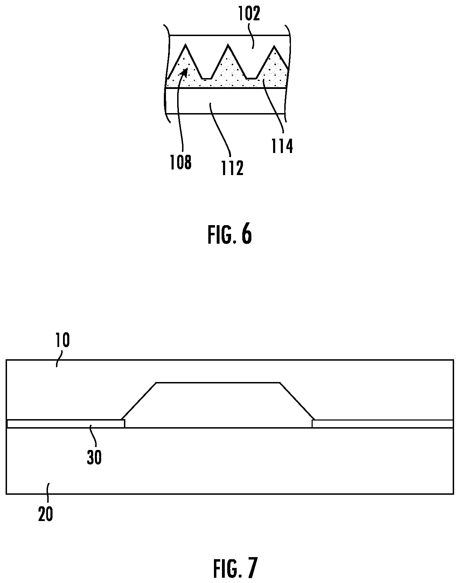

Traditional micro-electromechanical system (MEMS) pressure sensors include two or more processed wafers bonded together using a bonding material, such as a frit material, or metal bonding material. Wafer bonding is used to form cavities and sensor geometries to create MEMs pressure sensors. As shown in Fig. 7, one common application is the bonding of two wafers together for the formation of a cavity through the bonding of a device wafer 10 and a backing wafer 20 with predefined geometries using a frit material 30. The frit bonding process is accomplished by depositing frit material 30 through known methods, bringing the bonding wafers together and applying both heat and pressure which allows the frit to flow and create a hermetic seal around a sensor/vacuum cavity formed in the device wafer. The bonding faces of both the device and backing wafers art are typically flat to provide even stress distribution across the frit as it flows and bonds the wafers together.

In traditional bond interfaces, there are certain constraints regarding the maximum pressure that the sensor is capable of enduring before experiencing a failure. When used to preserve the hermetic seal of the sensor cavity, the design of the pressure sensor can be constrained to a certain minimum size to manage the bonding material's permeability. In traditional bond interfaces, a strong thermal connection between the device wafer and backing wafer is required when thermal isolation between the two wafers might be desired. In some traditional systems, there tends to be bonding quality variation due to manufacturing variabilities.

The conventional techniques have been considered satisfactory for their intended purpose. However, there is an ever present need for improved bonding between the device and backing wafers. This disclosure provides a solution for this need.

SUMMARY

A wafer die assembly includes a first wafer having at least a central cavity defined therein. The wafer die assembly includes a second wafer mounted to the first wafer with a bonding material. At least one of the first or second wafers includes an etched pattern. The etched pattern including at least one peripheral cavity, and a raised area raised relative to the peripheral cavity.

In accordance with some embodiments, the bonding material abuts the raised area and is positioned between the second wafer and the raised area. The central cavity can include at least one side wall. The bonding material can extend into the central cavity along the at least one side wall. The peripheral cavity can include at least one side wall. The bonding material can extend into the peripheral cavity along the at least one side wall.

In accordance with certain embodiments, the peripheral cavity can include a plurality of peripheral cavities. The plurality of peripheral cavities can be spaced apart from one another around the central cavity. Each of the plurality of peripheral cavities can include at least one side wall. The bonding material can extend into each of the plurality of peripheral cavities along the at least one side wall. The central cavity can have a rectangular shaped opening with a length side and a width side. Each of a first set of the plurality of peripheral cavities can have a length side that is arranged parallel to the width side of the central cavity. Each of a second set of the plurality of peripheral cavities can have a length side that is arranged parallel to the length side of the central cavity. The central cavity can have a rectangular shaped opening with a length side and a width side. The peripheral cavity can have a rectangular shaped opening with a length side and a width side. It is contemplated that the second wafer can include a through hole configured and adapted to act as a pressure port and provide fluid communication into the central cavity of the first wafer.

In some embodiments, the peripheral cavity can be at least one of a vacuum cavity, a gas filled cavity, and/or filled entirely with bonding material.

In accordance with another aspect, a method of assembling a wafer die assembly includes etching a central cavity into a first wafer. The method includes etching a pattern into at least one of the first wafer or a second wafer. At least one of the first wafer or the second wafer includes a raised area raised relative to the peripheral cavity of the central cavity. The method includes applying a bonding material to at least one of the first wafer or the second wafer. The method includes bonding the second wafer to the first wafer.

The method can include allowing the bonding material to flow into the peripheral cavity. The peripheral cavity can include at least one side wall. Allowing the bonding material to flow into the peripheral cavity can include allowing the bonding material to flow into the peripheral cavity along at least one side wall. The method can include allowing the bonding material to flow into the central cavity. The central cavity can include at least one side wall. Allowing the bonding material to flow into the central cavity can include allowing the bonding material to flow into the central cavity along the at least one side wall. The method can include forming a through hole in the second wafer. The method can include bonding the second wafer to the first wafer includes abutting the raised area of the first wafer onto the bonding material on the second wafer. The peripheral cavity can include a plurality of peripheral cavities. The plurality of peripheral cavities can be spaced apart from one another around the central cavity.

In some embodiments, etching the pattern includes etching a plurality of patterns into at least one of the first wafer or second wafer. The method can include separating the first wafer and the second wafer into respective dies. Each die can include one of the plurality of patterns.

These and other features of the systems and methods of the subject disclosure will become more readily apparent to those skilled in the art from the following detailed description of the preferred embodiments taken in conjunction with the drawings.

## BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:

Fig. 1 is a schematic depiction of a cross-sectional view of a wafer die assembly constructed in accordance with an embodiment of the present disclosure, showing the frit bond between the device wafer and the backing wafer with a vacuum cavity and peripheral cavities between the two wafers;

Fig. 2A is a schematic depiction of a bottom elevation view of the device wafer of Fig. 1, showing the etched pattern;

Fig. 2B is a schematic depiction of a bottom elevation view of the device wafer of Fig. 1, showing another embodiment of an etched pattern with continuous concentric peripheral cavities; and

Fig. 3 is a schematic depiction of a cross-sectional view of a wafer die assembly constructed in accordance with another embodiment of the present disclosure, schematically showing a leakage path;

Fig. 4 is a schematic depiction of a bottom plan view of a device wafer constructed in accordance with another embodiment of the present disclosure, showing wider peripheral cavities;

Fig. 5 is a schematic depiction of a cross-sectional view of a wafer die assembly constructed in accordance with another embodiment of the present disclosure, showing the frit bond between the device wafer and a backing wafer having a pressure port;

Fig. 6 is a schematic cross-sectional view of a portion of the wafer die assembly of Fig. 1, showing bonding material filling the entire peripheral cavity; and

Fig. 7 is a schematic depiction of a cross-sectional view of a traditional wafer die assembly, showing the frit bond between the device wafer and a backing wafer.

## DETAILED DESCRIPTION OF THE PREFERRED EMBODIMENTS

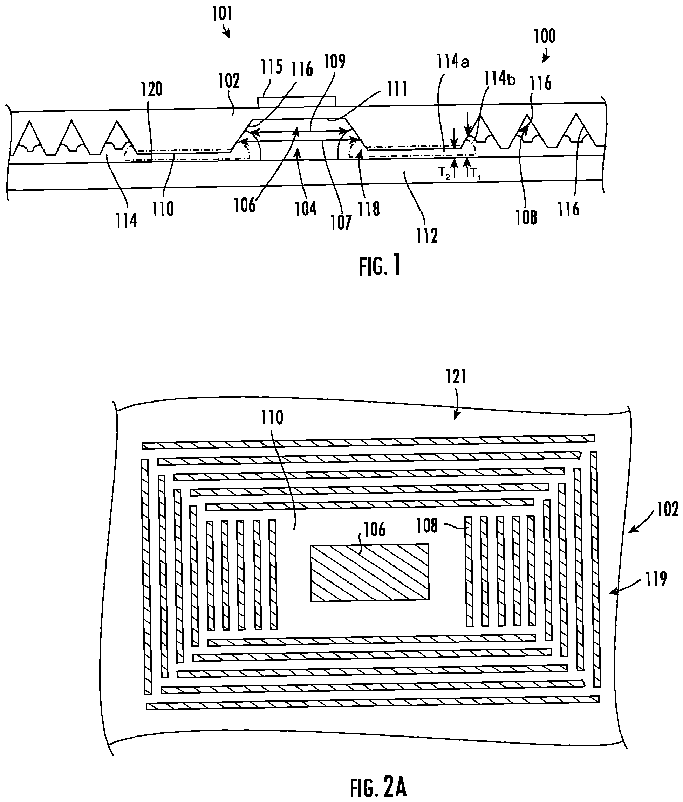

Reference will now be made to the drawings wherein like reference numerals identify similar structural features or aspects of the subject disclosure. For purposes of explanation and illustration, and not limitation, a schematic view of an exemplary embodiment of the wafer die assembly in accordance with the disclosure is shown in Fig. 1 and is designated generally by reference character 100. Other embodiments of the wafer die assembly and sensor system associated therewith in accordance with the disclosure, or aspects thereof, are provided in Figs. 2A-6 as will be described. The systems and methods described herein provide a wafer die assembly for use in a MEMs pressure sensor having an etched topology between two wafers which are to be bonded through the use of a bonding material, e.g., a frit material, which metal bond material, or the like. "Frit material" is a general term used in the art to describe a meltable glass or a mixture containing a meltable or fusible glass. The etched topology includes cavities that act to control bonding material flow during the bonding process, providing more force in desired locations and prompting more flow in desired locations that will determine the maximum pressure application in which the pressure sensor can sustain.

As shown in Figs. 1-2A, a wafer die assembly 100 includes a device wafer, e.g., first wafer 102, having an etched pattern 104. In the embodiment of Fig. 1, etched pattern 104 includes a central cavity 106 that is a vacuum cavity and a plurality of peripheral cavities 108 that are vacuum cavities. Those skilled in the art will readily appreciate that while shown as vacuum cavities, cavities 106 and 108 can be backfilled with a gas, e.g. they can be gas filled cavities. Peripheral cavities 108 are spaced apart from one another around central cavity 106, where the spacing can be in both a width and length direction. The depths of peripheral cavities 108 can be different from the depth of central cavity 106.

Central cavity 106 defines a thinner wafer portion 125 having a MEMS circuit 115. Together with MEMS circuit 115, wafer die assembly 100 forms a MEMS pressure sensor 101. Etched pattern 104 is formed by structural patterning methods, such as KOH etching. In this way, it is possible to modify the bonding interface of first wafer 102 to create a topology, or a designed non-flat geometry, which provides a multitude of benefits and advantages over the prior art.

As shown in Fig. 2A, central cavity 106 has a rectangular shaped opening with a length side and a width side. In a first set 119 of peripheral cavities 108, each peripheral cavity 108 has a length side that is arranged parallel to the width side of central cavity 106. Each of a second set 121 of plurality of peripheral cavities 108 have a length side that is arranged parallel to the length side of central cavity 106. The peripheral cavities 108 include a rectangular shaped opening with a length side and a width side.

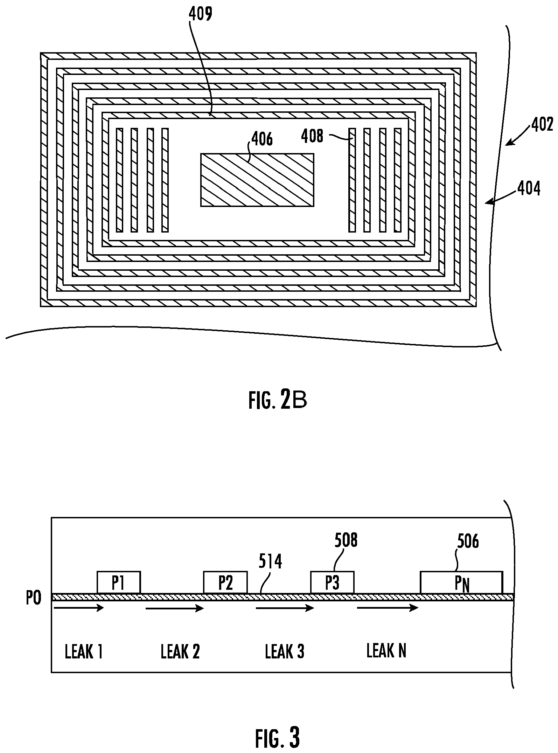

With reference now to Fig. 2B, another embodiment of an etched pattern 404 in a first wafer 402 is shown. In etched pattern 404, some of peripheral cavities 408 are continuous peripheral cavities 409 etched around a central cavity 406 (which is the same as central cavity 106). Peripheral cavities 408 are generally the same as peripheral cavities 108 except that some of peripheral cavities 408 along the length side of central cavity 406 each connect with a respective one of the peripheral cavities along the width side of central cavity 406 to form continuous peripheral cavities 409. In the embodiment of Fig. 2B, several peripheral cavities 408 extending along a width side of central cavity 406 are not connected to cavities on other sides.

As shown in Fig. 1, between central cavity 106 and one of peripheral cavities 108, first wafer 102 includes a raised area 110 raised relative to central cavity 106 and spaced apart peripheral cavities 108. Raised area 110 is also between respective peripheral cavities 108. Wafer die assembly 100 includes a backing wafer, e.g., a second wafer 112, mounted to first wafer 102 with a bonding material 114. First and second wafers, 102 and 112, respectively, are silicon wafers, or made from another suitable semi-conductor material. The area where first wafer 102 and second wafer 112 abut bonding material 114 is referred to as a bonding interface 118. Those skilled in the art will readily appreciate that, in the embodiment of Fig. 1, etching is performed only on first wafer 102, e.g. the device wafer. In other embodiments, etching may be applied to either or both bonding wafers 102 and 112. For example, device wafer 102 may have central cavity 106 etched therein, while peripheral cavities 108 are etched into second wafer 112.

With continued reference to Fig. 1, the use of peripheral cavities 108 in bonding interface 118 around central cavity 106 (whether cavities 108 are formed on second wafer 112 or on first wafer 102) provide a set of options and variations to the wafer bond. By etching these peripheral cavities 108 into a face of first wafer 102, and effectively removing surface area from the bonding region, the pressure applied to the remaining raised area 110 during the bond process is increased proportionally to the area removed (both at a local average of stress during bond, and a "global" average across the wafer). This results in improved bonding material flow in the bonding region, allowing for bonding material flow up side walls 116 of central cavity 106 and up side walls 116 of peripheral cavities 108. This flow generates a thickened bonding material 114b and a thinned bonding material 114a, the thickened bonding material 114b which is flowing up the cavity wall. The bonding flow enabled by the embodiments of this disclosure results in a thickness ($T_1$) of thickened bonding material 114b to be two times or greater a thickness ($T_2$) of the thinned bonding material 114a. $T_1$ is taken in a direction perpendicular to second wafer 112, between the second wafer 112 and the highest point along side wall 116 that thickened bonding material 114b reaches. $T_2$ is taken in a direction perpendicular to second wafer 112 between second wafer 112 and raised area 110.

Fig. 1 shows vacuum filled peripheral cavities 108 with improved frit contact on side walls 116, as well as a trapped vacuum chamber in cavities 108. Those skilled in the art will readily appreciate that while frit material 114 is shown as only partially up side walls 116, it is contemplated that in some embodiments, frit material 114 could entirely fill one or more of peripheral cavities 108. This is shown schematically in Fig. 6, where frit material 114 is shown with stippling to distinguish between empty cavity space. The placement of narrow peripheral cavities 108 around the outside of the frit bonding region of central cavity 106 allows for the manipulation of bonding force that is applied near central cavity 106 specifically, during the wafer bonding process, enhancing the desired effect of improved frit flow up side walls 116 of central cavity 106. In addition, the minimum size of the overall pressure sensor generated with die 100 is partially governed by the frit's lateral width, requiring a minimum amount of material to assure a certain resistance to diffusion between the sensor cavity and the environment. The embodiment of the present disclosure would allow for smaller sensors to be made than previously possible, resulting in overall cost and size reductions for a sensor device utilizing the die assembly 100, such as a pressure transducer.

With continued reference to Fig. 1, improving bonding material contact up and along cavity side walls 116, especially along side walls 116 of central cavity 106, is advantageous, as it reinforces the critical dimension pertaining to the internal burst pressure of central cavity 106. According to crack propagation theory, if central cavity 106 is pressurized, the widest dimension inside that cavity is subjected to the most stress. With the improved bonding material to wall contact due to improved bonding material flow, the widest dimension for an etched cavity (e.g. a KOH etched cavity) is precisely the location that the bonding material would reinforce, thus improving the burst resilience of the sensor cavity. Bonding material flow for a traditional die is shown schematically in Fig. 1 by the broken lines. Arrow 107 shows where traditional bonding material flow up side walls 116 would be. Bonding material 114 of the present disclosure is shown up along more of side walls 116, closer to a cavity base surface 111. The increased bonding material flow, as an example, reaches the second arrow 109, which is an improvement relative to arrow 107. As bonding material flow is increased up side walls 116, bonding material thickness is proportionally reduced between raised areas 110 and a mating surface 120 of second wafer 112. This allows the local stresses implored at the burst dimension to be further distributed throughout the silicon of first wafer 102. Silicon is a heterogeneous crystalline material that is more resilient to stress, which reduces the need to rely mainly on bonding material resilience to hold the bond.

As shown in Figs. 1-2, in addition to improved bonding material contact, embodiments of the present disclosure act to improve sensor hermetic seal and reduces the permeability of the bonding material 114 through two mechanisms. First, by proportionally thinning the frit between wafers 102 and 112 (as described above), the permeable path is narrowed, reducing diffusion through the amorphous frit material 110 and thus improving the isolation between central cavity 106 and the external environment. Fig. 1 schematically shows the thickness of a frit material between a device wafer and a backing wafer in a traditional MEMS die using broken lines. Embodiments of the present disclosure have a thinner frit material layer 114 between raised areas 110 and mating surface 120 of second wafer 112. Second, peripheral cavities 108 (which are vacuum cavities) act as diffusion sinks for permeable gases which have diffused through frit material 114 during the bonding process. These cavities act as an equivalent double vacuum chamber, or a mathematically equivalent electrical capacitor, protecting the central cavity 102 from diffusion effects. This is shown by the pressure equation (Equation 1) below, where $P_i$ is the pressure in a given peripheral cavity 108, t is time, $e$ is Euler's Number, and $\tau$ is a time constant.

Equation 1:

$$P_i = P_{i-1}\left(1 - e^{-t/\tau}\right) \approx P_{i-1}\left(\frac{t}{\tau}\right)$$

For embodiments where central cavity 106 and peripheral cavities 108 are vacuums, leakage may stem from the external environment coming inside peripheral cavities 108 and then to central cavity 106. This is schematically indicated by the leakage flow shown in Fig. 3. In Fig. 3, a central cavity 506 and peripheral cavities 508 are shown between two wafers bonded together with bonding material 514. Central cavity 506 and peripheral cavities 508 are similar to central cavity 106 and peripheral cavities 108 except that the shapes and spacing are different. When determining the pressure ($P_n$) in central cavity 506, the pressure is attenuated by the power of the number (n) of peripheral cavities 508 surrounding central cavity 506, which is much more than making a single longer leakage path which would only have linear attenuation per length. The pressure equation for the pressure ($P_n$) in central cavity 506 is shown below, where $P_0$ is the external pressure, t is time, and $\tau$ is a time constant.

Equation 2:

$$P_n \approx P_0\left(\frac{t}{\tau}\right)^n$$

Those skilled in the art will readily appreciate that this seal techniques works to both keep unwanted fluid out, as well as the wanted fluid contained. For embodiments where central cavity 106 and peripheral cavities 108 are backfilled with a gas and the gas leaks from the center of the device, e.g. ($P_n$) as shown in Fig. 3, out to the edges, determining the pressure in the final peripheral cavity ($P_1$), e.g., that furthest from its respective central cavity 106, the pressure is attenuated by the power of the number of cavities (n), which is much more than making a single longer leakage path which would only have linear attenuation per length. This allows leakage to be attenuated in both directions, where the central cavity can be maintained either as a vacuum or a gas (fluid) environment.

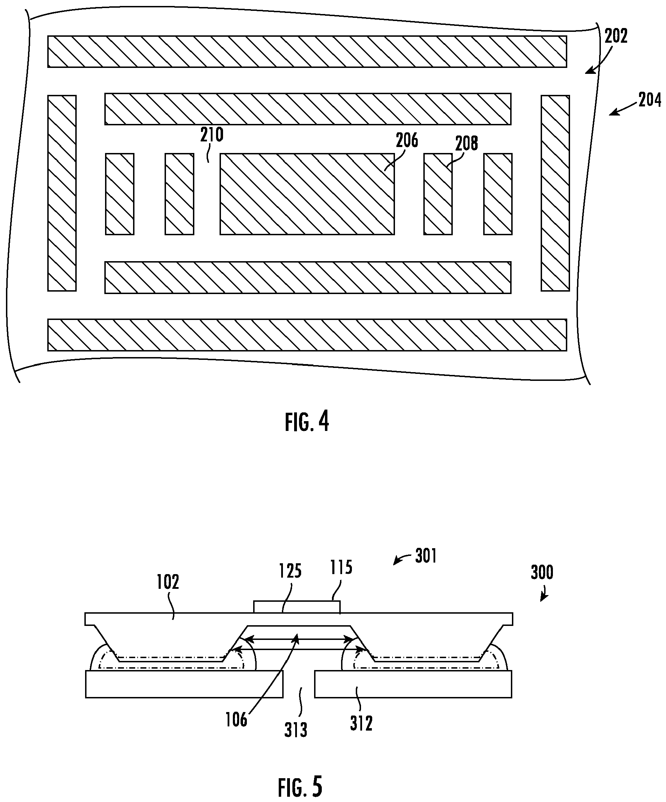

With continued reference to Fig. 1, in addition to improved hermetic sealing, vacuum filled peripheral cavities 108 also result in improved thermal resistance between the bonding wafers 102 and 112. This can be a desirable effect, as, when assembled into a MEMs sensor package the second wafer 112 is typically thermally tied to the sensor's packaging. Moreover, depending on the application, the thermal variation of the environment can be a notable source of error in sensor performance. Sensors could be designed with wider (e.g., similar to those of Fig. 4), more plentiful vacuum cavities in the base wafer 112 to achieve thermal isolation from the environment in which it operates.

As shown in Figs. 1-2B and 4-5, the addition of etched pattern 104/204/404 has also been observed to improve bond quality and uniformity in manufacturing environments. The increased frit flow into the peripheral cavities 108 has shown to produce a more uniform cross wafer frit material 114 thickness. With uniformity improvements, MEMS die yield from a given wafer sheet assembly is subsequently and significantly improved. The possibility of leakage paths due to defects such as frit voids is decreased. This is an improvement compared with traditional frit bonding where there is increased variation in wafer frit thickness. Thicker frit requires a longer processing time at bond temperature than thinner frit, so variation in thickness presents the risk of underbaking the thicker frit sections or overbaking the thinner frit sections. If frit is allowed to remain at bond temperature for longer than necessary, it could lead to unintended stress in the silicon. If frit is not allowed to remain at bond temperature (e.g., underbaked), it will not fully flow leading to the presence of voids. As depicted in Figs. 1 and 5, frit material 114 is thinner and has more cross-wafer thickness uniformity as compared with traditional MEMS dies. This acts to reduce the risks surrounding thermal exposure during the bond process. Etched pattern 104 improves manufacturing die yields and decreases variation.

As shown in Fig. 4, another embodiment of a first wafer 202 is shown. First wafer 202 is the same as first wafer 102 except for that wafer 202 has wider peripheral cavities 208 than peripheral cavities 108 of first wafer 102. Peripheral cavities 108 and 208 can be wider or narrower, depending on the desired application. Narrow cavities, like cavities 108, can be used to modify pressure during bonding locally within the die. Whereas wider cavities, e.g. like peripheral cavities 208, may be better under vacuum. Both cavities can still accomplish all of the advantages of increased burst resilience, improved hermetic sealing, modifiable thermal isolation, and bonding variations, as described above for Figs. 1-3. First wafer 202 can readily replace wafer 102 in wafer die assembly 100. Or, the etched pattern of peripheral cavities 208 on wafer 202 can readily be applied to backing wafer 112. First wafer 202 can readily be bonded to backing wafer 112, in the same manner as first wafer 102 and backing wafer 112 are bonded together. First wafer includes a raised area 210 raised relative to the central cavity 206 and the spaced apart peripheral cavities 210.

In accordance with another aspect, a method of assembling a wafer die assembly, e.g. wafer die assembly 100, includes etching a pattern, e.g. pattern 104, into a first wafer, e.g. first wafer 102. The pattern includes a central cavity, e.g. central cavity 106, and at least one peripheral cavity, e.g. peripheral cavity 108. The method includes applying a bonding material, e.g. frit material 114, to a second wafer, e.g. second wafer 112. The method includes bonding the second wafer to the first wafer. The method includes allowing the frit material to flow into the peripheral cavity. Allowing the frit material to flow into the peripheral cavity includes allowing the frit material to flow into the peripheral cavity along at least one side wall, e.g., side walls 116. The method includes allowing the frit material to flow into the central cavity. Allowing the frit material to flow into the central cavity includes allowing the frit material to flow into the central cavity along the at least one side wall. In accordance with some embodiments, the method includes forming a through hole in the second wafer. The method includes bonding the second wafer to the first wafer by abutting the raised area of the first wafer onto the frit material on the second wafer. In some embodiments, etching the pattern includes etching a plurality of patterns, e.g., the same as pattern 104, multiple times into first wafer 102. The method further includes separating the first wafer and the second wafer into respective dies, wherein each die includes one of the plurality of patterns on the first wafer bonded to the second wafer.

With reference now to Fig. 5, in another embodiment of wafer die assembly 300, a second wafer 312 includes a through hole 313 configured and adapted to act as a pressure port and provide fluid communication into central cavity of the first wafer. Other than the through hole 313, wafer die assembly 300 is the same as wafer die assembly 100. In this embodiment, central cavity 106 defines a thinner wafer portion 125 having a MEMS circuit 115. Together with MEMS circuit 115, wafer die assembly 300 forms a MEMS pressure sensor 301. Wafer 102 in Fig. 5 is the same as wafer 102 of Fig. 1. Through hole 313 allows a mems circuit 115 and wafer die assembly 300 to act as a pressure sensor.

The methods and systems of the present disclosure, as described above and shown in the drawings, provide for MEMS dies having an etched topology with superior properties including reduced permeability between the sensor cavity and environment, optional thermal isolation between the device and backing wafer, resilience to burst failures in a MEMS pressure sensor, and, if desired, the capacity for forming smaller MEMs die and pressure sensors than allowed in the prior art. The systems and methods of the present invention can apply to MEMS sensors or the like. While the apparatus and methods of the subject disclosure have been shown and described with reference to preferred embodiments, those skilled in the art will readily appreciate that changes and/or modifications may be made thereto without departing from the scope of the invention as defined by the claims.

**Claims**

1. A wafer die assembly comprising:

   a first wafer (102) having at least a central cavity (106) defined therein; and
   a second wafer (112) mounted to the first wafer, wherein at least one of the first or second wafers includes an etched pattern (104), the etched pattern including at least one peripheral cavity (108), and a raised area (110) raised relative to the peripheral cavity

2. The wafer die assembly as recited in claim 1, wherein the second wafer is mounted to the first wafer with a bonding material, wherein the bonding material abuts the raised area and is positioned between the first or second wafer and the raised area.

3. The wafer die assembly as recited in claim 2, wherein the central cavity includes at least one side wall, wherein the bonding material extends into the central cavity along the at least one side wall and/or wherein the peripheral cavity includes at least one side wall, wherein the bonding material extends into the peripheral cavity along the at least one side wall.

4. The wafer die assembly as recited in any preceding claim1, wherein the peripheral cavity includes a plurality of peripheral cavities, wherein the plurality of peripheral cavities are spaced apart from one another around the central cavity.

5. The wafer die assembly as recited in claim 4, wherein the second wafer is mounted to the first wafer with a bonding material, wherein each of the plurality of peripheral cavities includes at least one side wall, wherein the bonding material extends into each of the plurality of peripheral cavities along the at least one side wall.

6. The wafer die assembly as recited in claim 4, wherein the central cavity has a rectangular shaped opening with a length side and a width side, wherein each of a first set of the plurality of peripheral cavities have a length side that is arranged parallel to the width side of the central cavity, and optionally wherein each of a second set of the plurality of peripheral cavities have a length side that is arranged parallel to the length side of the central cavity.

7. The wafer die assembly as recited in any preceding claim, wherein the central cavity has a rectangular shaped opening with a length side and a width side and/or wherein the peripheral cavity has a rectangular shaped opening with a length side and a width side.

8. The wafer die assembly as recited in any preceding claim, wherein the peripheral cavity is at least one of a vacuum cavity, a gas filled cavity, or filled entirely with bonding material.

9. The wafer die assembly as recited in any preceding claim, wherein the second wafer includes a through hole (313) configured and adapted to act as a pressure port and provide fluid communication into the central cavity of the first wafer.

10. A method of assembling a wafer die assembly, the method comprising:

   etching a central cavity (106) into a first wafer (102);
   etching a pattern into at least one of the first wafer or a second wafer (112), wherein the pattern includes at least one peripheral cavity (108), wherein at least one of the first wafer or the second wafer includes a raised area (110) raised relative to the peripheral cavity; and
   bonding the second wafer to the first wafer.

11. The method as recited in claim10, further comprising applying a bonding material to at least one of the first wafer or the second wafer and allowing the bonding material to flow into the peripheral cavity.

12. The wafer die assembly as recited in claim11, wherein the peripheral cavity includes at least one side wall, wherein allowing the bonding material to flow into the peripheral cavity includes allowing the bonding material to flow into the peripheral cavity along the at least one side wall.

13. The method as recited in claim 1 0, further comprising applying a bonding material to at least one of the first wafer or the second wafer and allowing the bonding material to flow into the central cavity, and optionally wherein the central cavity includes at least one side wall, wherein allowing the bonding material to flow into the central cavity includes allowing the bonding material to flow into the central cavity along the at least one side wall.

14. The method as recited in any of claims 10 to 13, further comprising forming a through hole in the second wafer and/or wherein bonding the second wafer to the first wafer includes abutting the raised area on the at least first or second wafer with the bonding material on at least one of the first or the second wafer.

15. The method as recited in any of claims 10 to 14, wherein etching the pattern includes etching a plurality of patterns into at least one of the first or second wafer, the method further comprising separating the first wafer and the second wafer into respective dies, wherein each die includes one of the plurality of patterns.

FIG. 1

FIG. 2A

409

402

404

406  408

FIG. 2B

508

506

514

P1    P2    P3    PN

PO

LEAK 1    LEAK 2    LEAK 3    LEAK N

FIG. 3

FIG. 4

FIG. 5

102

108 112 114

**FIG. 6**

10

30

20

**FIG. 7**

Europäisches
Patentamt

European
Patent Office

Office européen
des brevets

# EUROPEAN SEARCH REPORT

Application Number

EP 24 15 3916

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 00/73090 A1 (VAGANOV VLADIMIR I [US]) 7 December 2000 (2000-12-07) * page 4, line 13 - line 15 * * page 10, line 29 - line 36 * * figures 4,7,36-55 * | 1-15 | INV. B81C3/00 G01L9/00 |
| X | US 2002/106862 A1 (JORDAN LARRY L [US] ET AL) 8 August 2002 (2002-08-08) * paragraphs [0014], [0016], [0020], [0021] * * figure 1 * | 1,10 | |

TECHNICAL FIELDS
SEARCHED      (IPC)

B81C
B81B
G01L

The present search report has been drawn up for all claims

| Place of search | Date of completion of the search | Examiner |
|---|---|---|
| Berlin | 5 June 2024 | Foussier, Philippe |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
....................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 15 3916

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2024

| Patent document cited in search report | | Publication date | Patent family member(s) | | Publication date |
|---|---|---|---|---|---|
| WO 0073090 | A1 | 07-12-2000 | EP | 1272361 A1 | 08-01-2003 |
| | | | US | 6406636 B1 | 18-06-2002 |
| | | | WO | 0073090 A1 | 07-12-2000 |
| US 2002106862 | A1 | 08-08-2002 | US | 2002106862 A1 | 08-08-2002 |
| | | | US | 2003157426 A1 | 21-08-2003 |

EPO FORM P0459

For more details about this annex : see Official Journal of the European Patent Office, No. 12/82